# EUROPEAN PATENT SPECIFICATION

(11) **EP 4 521 471 B1**
(45) Date of publication and mention of the grant of the patent: **19.08.2026**
(21) Application number: 23799529.5
(22) Date of filing: 16.02.2023
(51) Int. Cl.: H02S 20/22, H02S 20/26, H10F 19/80, H10F 77/00, H02S 30/10

(54) **SOLAR COLOR MODULE AND COLOR TUNABLE SOLAR MODULE**
SONNENFARBMODUL UND FARBABSTIMMBARES SOLARMODUL
MODULE DE COULEUR SOLAIRE ET MODULE SOLAIRE RÉGLABLE EN COULEUR

(30) Priority: 04.05.2022 KR 20220055660
(43) Date of publication of application: 12.03.2025
(73) Proprietor: RESEARCH INSTITUTE OF INDUSTRIAL SCIENCE & TECHNOLOGY, Pohang-si, Gyeongsangbuk-do 37673 (KR)
(72) Inventor: KIM, Young-Su, Pohang-si, Gyeongsangbuk-do 37667 (KR); KIM, A-Rong, Pohang-si, Gyeongsangbuk-do 37673 (KR); TARK, Sung-Ju, Pohang-si, Gyeongsangbuk-do 37673 (KR)
(74) Representative: Kador & Partner Part mbB
(86) International application number: PCT/KR2023/002285
(87) International publication number: WO 2023/214646

(56) References cited:
- WO-A1-2021/009719
- WO-A1-2021/009719
- JP-B2- 3 805 996
- KR-A- 20120 016 903
- KR-A- 20130 047 876
- KR-A- 20130 047 876
- KR-A- 20150 091 657
- KR-A- 20150 091 657
- KR-A- 20220 029 203
- KR-B1- 102 060 695
- US-A1- 2012 152 320
- GEWOHN TIMO ET AL: "Postproduction Coloring of Photovoltaic Modules With Imprinted Textiles", IEEE JOURNAL OF PHOTOVOLTAICS, IEEE, vol. 11, no. 1, 16 November 2020 (2020-11-16), pages 138 - 143, XP011827781, ISSN: 2156-3381, [retrieved on 20201218], DOI: 10.1109/JPHOTOV.2020.3034001

## Description

### Technical Field

The present disclosure relates to a solar color module or a color variable solar module formed so that colors may be changed in a solar module.

### Background Art

Recently, in accordance with the goal of carbon neutrality, various technologies are being used to implement zero energy houses to reduce carbon emissions. There among, there are provided solar technologies, which are representative technologies, related to solar technology, known as Building Attached Photovoltaic (BAPV) and Building Integrated Photovoltaic (BIPV) technologies, which attach a solar module to a rooftop or an exterior wall of a building, which are receiving attention. A Building Integrated Photovoltaic (BIPV) module is a building material replacing a building exterior material and performing both the functions of the building exterior material and the solar module.

A silicon solar cell, which is most commonly used in production of a solar module, is opaque and monochromatic, so the silicon solar cell is difficult to expect an aesthetic effect from when applied to building. To improve this, a method such as attaching a colored PolyVinyl Butyral (PVB) film to protective glass or forming a colored film or a color layer separately thereon below an Ethylene Vinyl Acetate (EVA) film has been developed. Recently, in order to use a building integrated solar cell, a technology in which a patterned layer with a pattern is inserted into a lower portion of the glass, so that a portion transmitting light generates power, and the remaining portion thereof form color to reflect light and hide a lower solar cell, has been introduced.

A color solar module using this technology also requires high reliability that can be guaranteed for 20 to 25 years, similar to a general solar cell module, and is generally difficult to replace once installed. However, when using a color solar module as a building exterior material, unlike a general solar module, aesthetic purposes take priority, so it is necessary to be able to change the color solar module to have different colors or shapes according to user preference.

In particular, road soundproofing wall facilities or fence-type solar power panels are often used for advertising purposes, so the pictures or colors used therein should be replaced. Therefore, if color of a color module can be easily changed, the cost can be greatly reduced, as compared to changing the entire module. However, due to reliability issues, a current color module adopts a permanently fixed structure, making it almost impossible to replace only the colored portion. Some patents have proposed a method of coupling displays such as LCDs to solar modules, but the method has not been widely commercialized. Therefore, there is a need to develop solar modules that do not have reliability problems and can replace colors.

(Patent Document 1) JP 2001-053298 A
For example, GEWOHN TIMO ET AL: "Postproduction Coloring of Photovoltaic Modules With Imprinted Textiles", IEEE JOURNAL OF PHOTOVOLTAICS, IEEE, vol. 11, no. 1, 16 November 2020 (2020-11-16), pages 138-143, discloses a customizable and potentially cost efficient technique of coloring photovoltaic modules by laminating colored textiles onto photovoltaic cover glass.
KR 2022 0029203 A discloses a solar cell module comprising: a first solar cell panel including a first lower protection member, a plurality of first solar cells absorbing light of a first wavelength band, and a first upper protection member; a second solar cell panel disposed on the first solar cell panel and including a first lower protection member, a plurality of second solar cells absorbing light in a second wavelength band different from the first wavelength band, and a second upper protection member; at least one spacer interposed between the first upper protection member and the second lower protection member to space the first and second solar cell panels from each other; and a frame enclosing the stacked structure including the first solar cell panel, at least one spacer, and the second solar cell panel.
JP 3 805996 B2 discloses a solar battery module, having a light gathering type laminated glass structure and another solar battery module having a light gather ing type double-layered structure, in both of which even the rear surfaces of solar battery cells which take into consideration fine appearance and design.
KR 102 060 695 B1 discloses a solar panel assembly having a variable-cover exterior panel comprising: an installation frame installed on an outer wall of a building; a photovoltaic module unit installed on the installation frame to convert sunlight energy into electric energy in front of the outer wall of the building; a variable-cover exterior panel arranged in front of the photovoltaic module unit and arranged to reciprocate between an opened position to expose the photovoltaic module unit to the outside and a closed position to cover the photovoltaic module unit from the outside; and a panel opening/closing driving unit arranged on the installation frame to drive the variable-cover exterior panel to allow the variable-cover exterior panel to reciprocate between the opened position and the closed position.

### Summary of Invention

### Technical Problem

The present disclosure is intended to solve the above problems, and an aspect of the present disclosure is to provide a color variable solar module or a solar color module that can change color by further forming a fixing portion so that a color layer may be changed.

### Solution to Problem

In order to achieve the above object, in the present disclosure, a color variable solar module according to claim 1 is provided.

According to an embodiment of the present disclosure, the solar color module includes a color layer forming color and a fixing portion coupling the color layer to a solar module so that the color layer may be installed on and removed from the solar module.

According to an embodiment of the present disclosure, the color variable solar module includes a solar cell generating power using incident sunlight; an encapsulate sealing the solar cell from the outside; a surface layer provided to protect the solar cell on a surface of the encapsulate; a frame fixing a structure of the solar cell, the encapsulate, and the surface layer; and a fixing portion attached to or formed integrally with the frame, and fixing the laminated color layers.

According to an embodiment of the present disclosure, the color variable solar module includes a solar cell generating power using incident sunlight; a first module including an encapsulant sealing the solar cell from the outside; a second module including a plate-shaped color layer forming color and facilitating light transmission; and a fixing portion in which a coupling structure is formed so that the first module and the second module may be coupled and separated, wherein the fixing portion further comprises a rotatable hinge portion.

### Advantageous Effects of Invention

As set forth above, according to an aspect of the present disclosure, through the structure described above, the present disclosure has an effect of replacing color in an existing solar module, or providing a solar module of which color may be replaced.

### Brief description of drawings

FIG. 1 is a cross-sectional view of a solar module without a color layer. (representing background art not part of the invention)
FIG. 2 is a cross-sectional view of a solar module including a color layer according to a first embodiment of the present disclosure. (representing background art not part of the invention)
FIG. 3 is a cross-sectional view of a solar module including a color layer according to a second embodiment of the present disclosure. (representing background art not part of the invention)
FIG. 4 is a cross-sectional view of a solar module when a color layer forms an optical pattern according to an embodiment of the present disclosure. (representing background art not part of the invention)
FIG. 5 is a cross-sectional view of a solar color module according to a third embodiment of the present disclosure. (a) in FIG. 5 is a cross-sectional view of a solar color module, and (b) in FIG. 5 is a cross-sectional view of a solar color coupled to a solar module without a color layer.
FIG. 6 is a perspective view of a fixing portion according to a third embodiment of the present disclosure.
FIG. 7 is a cross-sectional view of a color variable solar module according to fourth and fifth embodiments of the present disclosure. (a) in FIG. 7 is a cross-sectional view illustrating a state in which a first module and a second module according to the fifth embodiment are not coupled, and (b) in FIG. 7 is a cross-sectional view illustrating a state in which the first module and the second module are coupled.
FIG. 8 is a perspective view of a fixing portion according to fourth and fifth embodiments of the present disclosure.
FIG. 9 is a cross-sectional view of a color variable solar module according to a sixth embodiment of the present disclosure. (a) in FIG. 9 is a cross-sectional view illustrating a state in which a first module and a second module according to the sixth embodiment are not coupled, and (b) in FIG. 9 is a cross-sectional view illustrating a state in which the first module and the second module are coupled.
FIG. 10 is a perspective view of a fixing portion according to a sixth embodiment of the present disclosure.
FIG. 11 is a cross-sectional view of a color variable solar module according to a seventh embodiment of the present disclosure. (a) in FIG. 11 is a cross-sectional view illustrating a state in which a first module and a second module according to the seventh embodiment are not coupled, and (b) in FIG. 11 is a cross-sectional view illustrating a state in which the first module and the second module are coupled.
FIG. 12 is a perspective view of a fixing portion according to a seventh embodiment of the present disclosure.
FIG. 13 is a graph illustrating a degree of power loss as a color layer is added by measuring current density in the solar module.

### Mode for Invention

Hereinafter, specific embodiments of the present disclosure will be described with reference to the attached drawings.

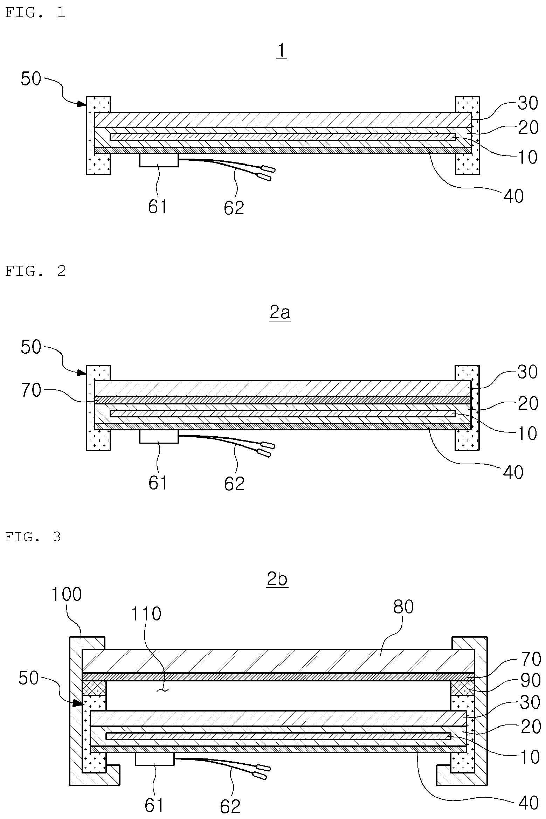

FIG.1 illustrates a solar module 1 without a color layer not forming part of the invention.

The solar module 1 is formed around a solar cell 10 receiving sunlight and generating power, and an encapsulant 20 is formed surrounding all surfaces of the solar cell, and the encapsulant 20 seals the solar cell 10 to prevent moisture or foreign substances from entering the solar cell 10 to protect the solar cell 10 from the outside.

A surface layer 30 is added to one surface of the encapsulant 20 to be formed to transmit sunlight and protect the solar cell 10 from external impacts. In order for the solar cell 10 located thereinside to generate power, the surface layer 30 has a very high degree of light transmittance. A back sheet 40 is further formed on an opposite side of the surface layer 30 of the encapsulant. This serves to protect the solar cell 10 from impacts and prevent external rainwater or foreign substances from entering thereinto. A frame 50 fixing the layered structure from a side surface may be further included. In addition, a wiring box 61 and a power line 62 connected to the back sheet 40 to connect power externally may be further included. In addition, all general components required for the solar module 1 may be included.

All embodiments to be described below include descriptions of the configuration of the solar module 1.

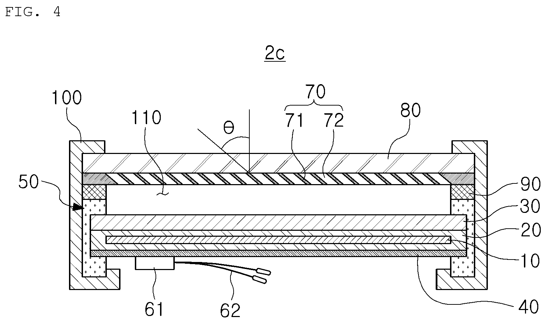

FIGS. 2 and 3 also providing background art not forming part of the invention illustrate solar modules 2a and 2b formed by integrally adding a color layer 70. FIG. 4 illustrates a case in which the color layer 70 of a solar module 2c is integrally formed by adding the color layer 70 to form an optical pattern.

According to aesthetic and commercial requirements, the solar modules 2a, 2b, and 2c are further provided with a color layer 70. The color layer 70 may use a material of cyanine dyes including at least one of metal ions of magnesium (Mg), nickel (Ni), copper (Cu), cobalt (Co), zinc (Zn), chromium (Cr), platinum (Pt), palladium (Pd), and iron (Fe). In addition, a front surface may be used as a continuous color layer 70 as illustrated in FIGS. 2 and 3. Alternatively, as illustrated in FIG. 4, a color developing layer 71 and a light transmitting layer 72 may be formed to have an inclination (θ) between 15 and 85 degrees from a vertical direction, based on a surface on which the color layer 70 is formed, to include an optical pattern. The color developing layer 71 is configured to display color, and the light transmitting layer 72 is configured to facilitate light transmission. When formed in this manner, the sunlight is maximally incident when the solar module 2c is installed vertically. The color layer 70 of all embodiments to be described below includes both a case in which the color layer 70 is formed continuously, as well as a case in which the color layer 70 is formed discontinuously, and includes the color developing layer 71 and the light transmitting layer 72.

Referring to FIG. 2, the solar module 2a including the color layer 70 in the first embodiment is further provided with a color layer 70 the encapsulant 20 and the surface layer 30. As the color layer 70 is positioned between the encapsulant 20 and the surface layer 30, the color layer 70 is colored when viewed from the outside. Even in this case, the frame 50 is formed to fix a layer structure including the color layer 70 from a side surface.

Referring to FIGS. 3 and 4 referring to background art not forming part of the invention, the solar modules 2b and 2c including the color layer 70 in the second embodiment further includes a cover window 80, a color layer 70, and a spacer 90 on a side on which sunlight is incident on the solar module 1 not including the color layer 70. That is, sunlight passes through an air layer 110 formed by the cover window 80, the color layer 70, and the spacer 90, and is incident thereon with a structure similar to the solar module 1 not including the color layer 70 described above.

The cover window 80 is formed so that sunlight is easily incident thereon, and protects the color layer 70 and other components located thereinside from external impacts. The cover window 80 is a layer configured for the same purpose as the surface layer 30, and may be formed of the same material. The color layer 70 is positioned as a layered structure in contact with the cover window 80. The color layer 70 is protected from the cover window 80 and is maintained without contact with air and moisture. A spacer 90 is provided between the color layer 70 and the frame 50, which has a structure configured to be similar to the solar module 1 without the color layer 70. The air present inside due to the spacer 90 forms an air layer 110, and the air layer 110 is maintained in a sealed state. The spacer 90 may be formed to have a certain thickness to maintain a height of a gap of the air layer 110 and to prevent gas included in the air layer 110 from being discharged externally. Then, a double frame 100 is fixed from the side so that the layer structure as described above is maintained. In addition, unlike when there is a frame 50, the spacer 90 may be located on one side of the frame 50, when there is no frame 50, the spacer 90 may be located in a certain section of the surface layer 30. In this case, all layer structures may be fixed with a double frame 100 without a frame 50.

The solar modules 2a, 2b, and 2c including the color layer 70 of the first and second embodiments are solar modules 2a, 2b, and 2c in which the color layer 70 is formed integrally, and there is a difficulty in changing the color, so an embodiment having a structure that can change the color layer 70 in which this problem has solved will be additionally described.

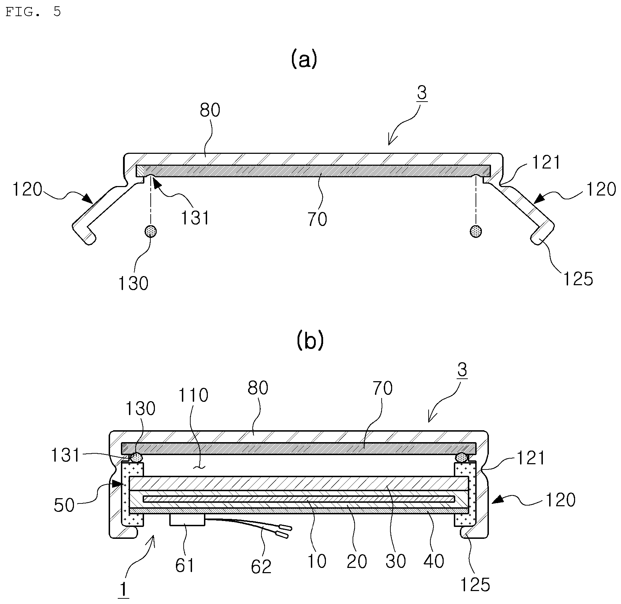

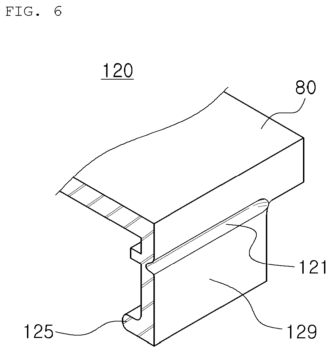

FIG. 5(a) illustrates a solar color module 3. FIG. 5(b) illustrates a state in which the solar color module 3 is coupled to the solar module 1 without the color layer 70. FIG. 6 is a perspective view of a fixing portion 120 of the solar color module 3.

A third embodiment is illustrated by referring to FIGS. 5(a) and 5(b). The solar color module 3 is configured to be coupled to the solar module 1. In the solar color module 3, a cover window 80 and a color layer 70 are tightly coupled in a layered structure in an order on which sunlight is incident. The solar color module 3 further includes a fixing portion 120 so that the color layer 70 may be coupled to and removed from the solar module 1. As mentioned above, the color layer 70 is configured to be coupled to the solar module 1 to display color, and the cover window 80 is also formed of a material that allows sunlight to pass therethrough, as described above, and is configured to be tightly coupled to the layer 70. Therefore, when viewed from the outside, it is configured to be colored by the color layer 70.

The solar color module 3 of the third embodiment further includes a fixing portion 120. The solar color module 3 includes a color layer 70 forming color, a cover window 80 provided in a layered structure with the color layer, and a fixing portion 120 coupling the color layer 70 to the solar module 1 so that the color layer 70 may be installed on and removed from the solar module 1.

When the color layer 70 is coupled to the solar module 1, a sealing member 130 sealing the air layer 110 formed by air located between the color layer 70 and the solar module 1, is further included.

Through the fixing portion 120, the color layer 70 and the cover window 80 can be used by coupling the same to the solar module 1 not including the previously installed color layer 70. In other words, the fixing portion has a structure that is coupled to the solar module 1 to be easily and removed. The fixing portion 120 may be formed integrally with the cover window 80, or may be formed separately. When formed separately, a color module frame (not shown) is further included, so that a structure of the color module can be fixed from the side surface, similar to the role of the frame 50 mentioned above. The fixing portion 120 includes all components which allow the solar color module 3 to be coupled to and then removed from the solar module 1 without the color layer 70. For example, it can be coupled using screws and bolts.

As an example of the fixing portion 120, the fixing portion 120 includes a hinge portion 121 formed to be rotatable and a locking portion 125 protruding so as to be coupled to one end of the solar module 1. The hinge portion 121 may include a general mechanical part formed to allow two fixed parts to move relative to each other. Due to this configuration, the locking portion 125 may be rotated outwardly and has a certain degree of freedom at an angle. The locking portion 125 may be configured to have an 'L' shaped cross-section to be coupled and fixed to a lower portion of the solar module 1. After the locking portion 125 is locked to the lower portion of the solar module 1, the locking portion 125 is configured to be fixed using the hinge portion 121 to be tightly fitted. If there is a shape that can be fixed by being locked to the solar module 1, the solar color module 3 may be configured to be fixedly coupled to the lower portion of the solar module 1, that is, the other portion, other than one end of the frame 50, through the hinge portion 121 and the locking portion 125 described above.

Since the present embodiment is coupled through this structure, an effect of easy removal is also provided. Therefore, when it is desired to change the color or pattern of the color layer 70, it can be easily replaced.

The hinge portion 121 is not a general mechanical structure that allows two parts to move relative to each other, but may be formed integrally with the fixing portion 120 and may be implemented by having a shape or material that is partially different from the fixing portion 120. For example, the fixing portion 120 may be formed to have a constant thickness, and may be comprised of a hinge portion 121 of which a thickness thereof is thinner than the constant thickness of the fixing portion 120. Therefore, the fixing portion 120 is formed in a structure that can be easily folded in the hinge portion 121, which has a relatively thin thickness. Alternatively, other portions of the fixing portion 120 may be formed at a constant density and have a lower density in the hinge portion 121 than that of the fixing portion 120, so that the fixing portion 120 may also be configured to be easily folded in the hinge portion 121. That is, when the hinge portion 121 is configured with a change in thickness or density, the hinge portion 121 may be formed of a material that is easily deformed, returns to an original state after deformation, and is not easily broken.

The locking portion 125 may be formed to have a protruding cross-section of one end shaped like a '⊏'. The locking portion 125 may be formed in a '⊏'-like structure in accordance with a lower structure of the solar module 1 to increase coupling force. The shape of the locking portion 125 will be described in detail below.

The solar color module 3 may further include a sealing member 130 located below the color layer 70. When the solar color module 3 is coupled to the solar module 1, an air layer 110 is formed therein. The sealing member 130 is configured to separate the air layer 110 formed therein from the outside for the reliability of the solar module 1, and prevent damage to the color layer 70 and the surface layer 30 during fixation and removal. The sealing member 130 also serves to prevent moisture from entering the interior of the solar module 1 which is coupled to the solar color module 3.

The sealing member 130 is formed of a material that is deformed to a certain degree by pressure but is not broken. For example, a high molecular weight polymer such as rubber may be used. The sealing member 130 is located close to the frame 50 of the solar module 1 and is located below the color layer 70. The sealing member 130 may be integrally attached to the solar color module 3, but may also be additionally fixed during installation. A first groove 131 formed to be concave is provided so that the sealing member 130 is positioned at a certain position, from an opposite side of the surface in which the color layer 70 is in close contact with the cover window 80. The depth of the first groove 131 may be thinner than the thickness of the color layer 70. Depending on the design, the sealing member 130 may contact the cover window 80 because the sealing member 130 is thicker than the color layer 70. A portion of the sealing member 130 is located in the first groove 131 and can be fixed so as not to move other than the portion in which the first groove 131 is formed. With this configuration, the sealing member 130 is prevented from moving out of its designed position and affecting reliability. In addition to the shape of the groove, the sealing member 130 may be fixed using all general fixing means such as an adhesive.

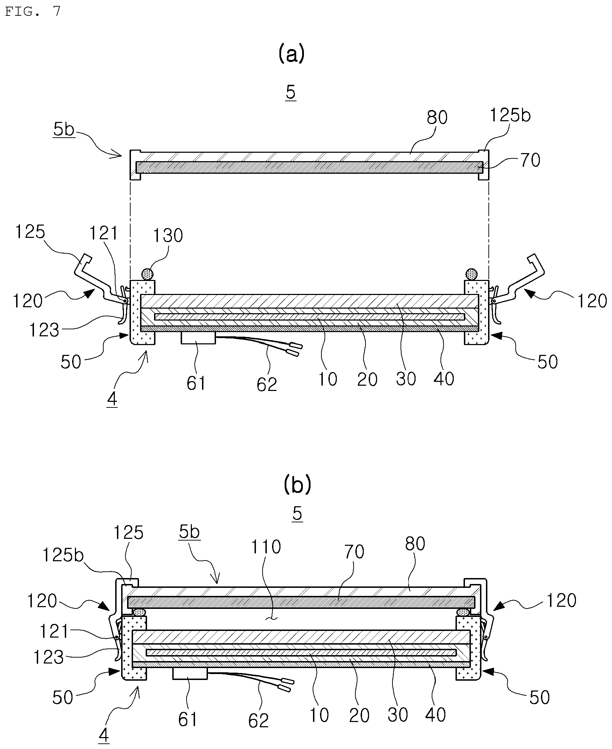

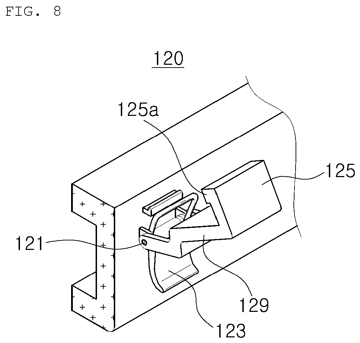

FIG. 7(a) illustrates a color variable solar module 4 including a fixing portion 120. FIG. 7(b) illustrates a form in which a color variable solar module 4 is coupled to a solar color module 5b. FIG. 8 illustrates a perspective view of the fixing portion 120 included in the color variable solar module 4.

The fourth embodiment illustrates a color variable solar module 4 to which the fixing portion 120 is coupled. The color variable solar module 4 may be coupled to the solar color module 5b provided with a color layer 70. The color variable solar module 4 includes a solar cell 10, an encapsulant 20, a surface layer 30, and a frame 50 fixing the layer structure, and include a fixing portion 120 coupled to the frame 50, or that can be added when coupled to the solar color module 5b.

The color variable solar module 4 includes a solar cell 10 generating power using incident sunlight, an encapsulant 20 sealing the solar cell 10 from the outside, a surface layer provided to protect the solar cell 10 on a surface of the encapsulant 20, a frame 50 fixing a structure of the solar cell 10, the encapsulant 20, and the surface layer 30, and a fixing portion 120 attached to or formed integrally with the frame 50 and fixing laminated color layers 70.

The color variable solar module 4 further includes a sealing member 130 which is in contact with the frame 50 or the surface layer 30 and is deformable according to pressure. The structure of the solar cell 10, encapsulant 20, surface layer 30, and frame 50 are the same as described above.

A side surface of the frame 50 may include a pressing portion 123 in addition to the hinge portion 121 and the locking portion 125 described above.

The fixing portion 120 may be formed and fixed by a hinge portion 121 and a locking portion 125 as described above. Another embodiment of the fixing portion 120 is as follows. Referring to FIGS. 7 and 8, a locking portion 125 fixed in a direction in which sunlight is incident so that a solar color module 5b including a color layer 70 positioned in the direction in which sunlight is incident through the locking portion 125, is formed. The locking portion 125 may be configured in a '∟' shape as described above, but a locking protrusion 125a at the end may be further formed in a '⊏' shape, so that the locking protrusion 125a may be coupled to an upper portion of the solar color module with a stepped structure 125b and increase a coupling force. In addition, a pressing portion 123 is formed so that a pressing portion 123 may be formed in the fixing portion 120, so when force is applied to the pressing portion 123, the locking portion 125 may be fixed, and may be formed in a structure in which the locking portion 125 in a fixed state is released when force is applied to the pressing portion in a direction opposite to the direction in which it is fixed. That is, when force is applied to the pressing portion 123 with the locking portion 125 positioned to fix the solar color module 5b, the locking portion 125 is configured so that the locking portion 125 is pulled due to the force applied to the pressing portion 123 connected to the hinge portion 121, and the hinge portion 121 is fixed without rotating in the pulled state. When the locking portion 125 is desired to be removed, when force is applied to the pressing portion 123 in the opposite direction, the coupling state is released and loosed, and the locking portion 125 may be rotated by the hinge portion 121, and thus the locking portion 125 may be easily removed. In this manner, it is formed so that the color layer can be coupled to and removed from the solar color module 5b.

The solar color module may further include a sealing member 130 which is in contact with the frame 50 or the surface layer 30 and is deformable according to pressure. Reliability of the color variable solar module 4 may be increased by further including a sealing member 130. The sealing member 130 may be attached to one end of the frame 50 coupled to the solar color module 5b. Even in this case, the fixed position may be prevented from being deviated through an inlet groove (not shown) formed in the surface layer 30 or the frame 50, and the sealing force can be increased. Other components that are not mentioned but have the same name are the same as those described above.

According to another embodiment, the first modules 4, 6a, and 7a and the second modules 5b, 6b, and 7b may be formed as a combination of color variable solar modules 5, 6, and 7 together with the fixing portion 120.

The color variable solar modules 5, 6, and 7 include first modules 4, 6a, and 7a, second modules 5b, 6b, and 7b, and a fixing portion 120. The first modules 4, 6a, and 7a are formed to include a solar cell 10 generating power using incident sunlight and an encapsulant 20 sealing the solar cell 10 from the outside. The second modules 5b, 6b, and 7b include a plate-shaped color layer 70 forming color, and a cover window 80 tightly coupled to an upper portion of the color layer 70. A fixing portion 120 is formed to allow the first modules 4, 6a, 7a and the second modules 5b, 6b, 7b to be coupled or separated. The fixing portion 120 may be integrally coupled to the first modules 4, 6a, and 7a or the second modules 5b, 6b, and 7b. Alternatively, when coupling the first modules 4, 6a, and 7a to the second modules 5b, 6b, and 7b, the fixing portion 120 may be installed together. The color variable solar modules 5, 6, and 7 below will be described in more detail as specific examples.

The color variable solar module 5 according to the fifth embodiment illustrates a case in which a fixing portion 120 is integrally provided with the first module 4.

The fixing portion 120 includes a rotatable hinge portion 121. As described above, the fixing portion 120 is formed to have a certain thickness or density, and the thickness of the hinge portion 121 may be thinner than the thickness of the fixing portion 120 or the density of the hinge portion 121 may be lower than that of the fixing portion 120.

Referring to FIGS. 7 and 8, a stepped structure may be formed on an external surface of the cover window 80 of the second module 5b. Alternatively, a second groove (not shown) may be formed to be concave from the surface of the cover window 80 in a direction in which the color layer 70 is coupled. In this case, a locking protrusion 125a in which one end of the fixing portion 120 is fixed to the first module 4 and the other end thereof is fitted into a second groove or a step formed in the second module 5b is included. The shape of the locking protrusion 125a may vary depending on the corresponding structure formed in the second module 5b.

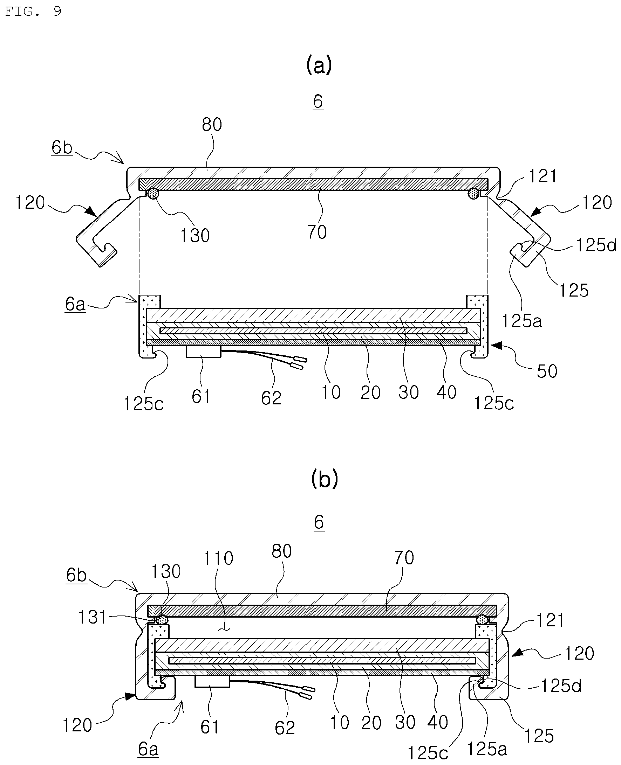

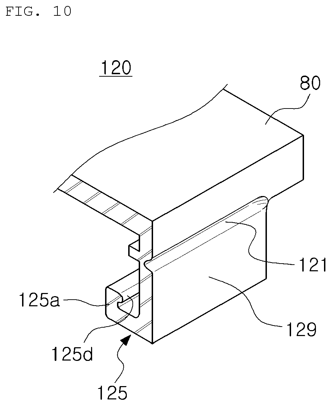

FIG. 9 illustrates a color variable solar module 6 when the fixing portion 120 is fixed or attached to a second module 6b. FIG. 9(a) illustrates a state in which a first module 6a and a second module 6b are separated, and FIG. 9(b) illustrates a state in which the first module 6a and the second module 6b are coupled. FIG. 10 illustrates a shape of another fixing portion 120.

A color variable solar module 6 according to a sixth embodiment may have a fixing portion 120 coupled to the second module 6b. In this case, the second module 6b has the same role and configuration as the solar color module 3 according to the third embodiment of the present disclosure. That is, the solar color module 3 includes a color layer 70 and a cover window 80, and the fixing portion 120 may be formed of a hinge portion 121 and a locking portion 125. However, in order to increase a coupling force between the first module 6a and the second module 6b, a structure in which the first module 6a and the second module 6b are coupled to each other by the fixing portion 120 may be changed.

In addition to the above-mentioned '∟' shape, the locking portion 125 of the fixing portion 120 may be formed in a '⊏'-like structure in accordance with a lower structure of the first module 6a to increase a coupling force in a lower portion thereof. In addition, in order to increase an internal sealing force by increasing the coupling force with the locking portion 125 of the fixing portion 120, a locking groove 125c may be formed in the frame 50 of the first module 6a, and a protruding portion 125d formed to protrude may be further included at the end of the locking portion 125 of the second module 6b. Accordingly, the protruding portion 125d is fitted into and coupled to the locking groove 125c, thereby increasing a degree of sealing and further increasing the coupling force. In addition, the shape of the locking portion 125 and the corresponding structure includes all structures that can be fixed to the frame 50 or a part other than the frame 50 of the first module 6a in addition to the above-mentioned shape. However, in this case, since it may be difficult to couple the same to each other, one end of the fixing portion 120, that is, the locking portion 125 may be formed of a shape or material of which a shape can be easily changed. For example, the locking portion 125 may be formed of a material such as silicon to be completely sealed and flexible. When coupled this structure, they are not easily separated even when unexpected vertical and lateral forces are applied, but have the effect of being able to separate when desired. However, it is not limited to these materials and shapes and includes all possible shapes and materials.

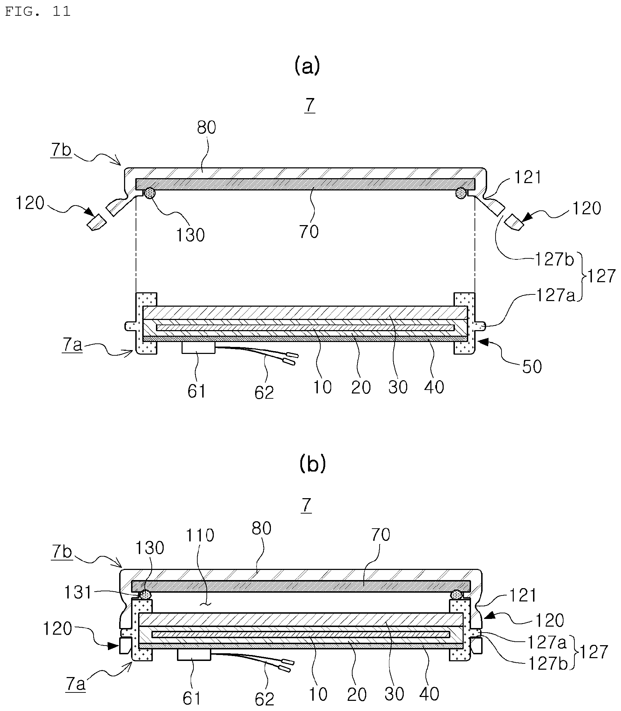

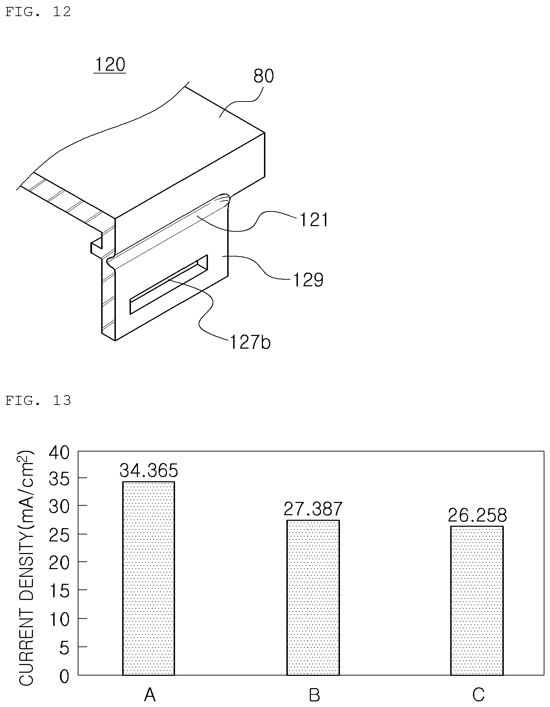

FIG. 11 illustrates another embodiment of the color variable solar module 7 when the fixing portion 120 is fixed or attached to the second module 7b. FIG. 11(a) illustrates a case in which the first module 7a and the second module 7b are separated, and FIG. 11(b) illustrates a case in which the first module 7a and the second module 7b are coupled. FIG. 12 illustrates the shapes of the hinge portion 121 and the fitting portion 127 included in the second module 7b.

According to a seventh embodiment, like the sixth embodiment, the fixing portion 120 may be coupled to a second module 7b. In this case, since the second module 7b has the same role and structure as the solar color module 3 of the third embodiment, the solar color module 3 includes a color layer 70 and a cover window 80. As another example of the fixing part 120, the fixing portion 120 may be formed of a hinge portion 121 and a fitting portion 127. The fitting portion 127 may be formed with a fitting groove 127b formed in a fitting protrusion 127a formed on the first module 7a and an extension surface 129 extending from the hinge portion 121 of the second module 7b. The hinge portion 121 in this embodiment is the same as the hinge portion 121 mentioned above. An extension surface 129 is formed extending from the hinge portion 121 of the fixing portion 120 attached to or included in the second module 7b and having a thickness, and a fitting groove 127b penetrates the extension surface 129 is formed. The fitting groove 127b may not penetrate depending on a degree of protrusion of the fitting protrusion 127a. A fitting protrusion 127a is formed in the first module 7a in a shape corresponding to the fitting groove 127b. The fitting protrusion 127a is generally formed on the frame 50 and is formed to protrude at a certain height. Accordingly, the first module 7a and the second module 7b may be coupled and separated through the fixing portion 120 including the hinge portion 121 and the fitting portion 127.

Even in the case of the fifth to seventh embodiments, a sealing member 130 may be further included in addition to the first modules 4, 6a, and 7a, the second modules 5b, 6b, and 7b, and the fixing portion 120. The function and effect of the sealing member 130 are the same as described above.

Unlike the first to second embodiments, in the third to seventh embodiments, the solar color module 3 or the second module 5b, 6b, 7b is connected to the existing color layer 70, since the solar color module 3 or the second modules 5b, 6b, and 7b may be coupled to or separated from the solar module 1 or the first modules 4, 6a, and 7a on which the existing color layer 70 is not formed, it has the effect of being able to replace the exterior of the building, remodeling, or changing the image used for fences and soundproof walls at a relatively low cost. In addition, since the technology of the solar module 1 developed for long-term use can be used as is and only the color or pattern can be changed, it can be an eco-friendly business model with less burden of replacement.

In addition, since the technology of the solar module 1 developed for long-term use can be used as is and only the color or pattern can be changed, it can be an eco-friendly business model with less burden of replacement. That is, the scattering layer may be formed in a layered structure to contact the color layer 70, and a separate scattering layer including TiO2 haze balls with a refractive index between 2.0 and 2.2 can be formed.

FIG. 13 is a graph comparing an amount of current generated in a solar module according to embodiments. Table 1 presents the results of the graph in FIG. 13 in a table.

**[Table 1]**

| SAMPLE | A(COMPARATIVE GROUP) | B(FIRST EMBODIMENT) | C(FIFTH EMBODIMENT) |
|---|---|---|---|
| CURRENT DENSITY(mA/cm²) | 34.365 | 27.387 | 26.258 |

Due to the addition of a cover window 80 and a color layer 70 to the solar module 1, there was a concern about a decrease in power generation, so a comparative experiment was conducted on three modules as shown in Table 1 and FIG. 13 above. Sample A is an existing solar module 1 without the color layer 70, and sample B is a solar module 2a of a second embodiment in which the color layer 70 cannot be changed. Sample C was tested with a color variable solar module 5 of a fifth example. A scattering layer was not included. All were manufactured using 1 Cell of 156mm X 156mm solar cell 1 cell, and the color of the color layer 70 was blue. Electrical properties were measured under standard conditions (25°C, 100mW/cm²) using the same experimental equipment. As a result, looking at the effect of insertion of the color layer 70, the current density decreased for both Sample B and Sample C compared to Sample A. Electrical properties were measured under standard conditions (25°C, 100mW/cm²) using the same experimental equipment. As a result, looking at the effect of insertion of the color layer 70, the current density decreased for both Sample B and Sample C compared to Sample A. However, a difference in the current density between sample C, where the color layer 70 is replaceable, and sample B, which is not replaceable, was only 4%, so the power generation loss was not high, even though the air layer 110 and the cover window 80 are added as the colors are interchangeable, so the cover window 80 and the color layer 70 may be formed not only in an integrated form, but also in a form in which the color of the cover window 80 and the color layer 70 may be changed by adding a fixing portion 120. From this, when comparing the degree of power generation by sunlight in the third to seventh embodiments with that of the first embodiment, it can be inferred that there is no significant difference. In the case of the second embodiment, the path through which sunlight passes is the same as that of the fifth embodiment, so it will not be discussed.

While example embodiments have been illustrated and described above, it will be apparent to those skilled in the art that modifications and variations could be made without departing from the scope of the present disclosure as defined by the appended claims.

## Claims

1. A color variable solar module (5, 6, 7), comprising:
a first module (4, 6a, 7a) including a solar cell (10) generating power using incident sunlight, and an encapsulant (20) sealing the solar cell (10) from the outside; and
a second module (5b, 6b, 7b) including a plate-shaped color layer (70) forming color and allowing light transmission;
wherein the color variable solar module (5,6,7) further comprises a fixing portion (120) in which a coupling structure allows the first module (4,6a,7a) and the second module (5b,6b,7b) to be coupled and separated,
**characterized in that** the fixing portion (120) further comprises a rotatable hinge portion (121).

2. The color variable solar module of claim 1, further comprising:
a cover window provided in a layered structure with the color layer.

3. The color variable solar module of claim 2, wherein a second groove or a step, formed to be concave on a surface of the cover window is formed, and
the fixing portion has one end attached to the first module and the other end including a locking protrusion fitted into the second groove or step.

4. The color variable solar module of claim 1, further comprising:
a sealing member located between the first module and the second module, and sealing air located between the first module and the second module.

5. The color variable solar module of claim 1, wherein the fixing portion is formed with a certain thickness or density, and
a thickness of the hinge portion is thinner than the thickness of the fixing portion or a density of the hinge portion is lower than the density of the fixing portion.

6. The color variable solar module of claim 4, wherein the sealing member is formed of a polymer that is deformable according to pressure.

7. The color variable solar module of claim 1, wherein the fixing portion is attached to or coupled to the second module,
the fixing portion further comprising:
a fitting groove formed to be concave on a surface formed to extend from the hinge portion, and
a fitting protrusion formed on the first module and corresponding to the fitting groove.

## Patentansprüche

1. Farbvariables Solarmodul (5, 6, 7), umfassend:
ein erstes Modul (4, 6a, 7a), das eine Solarzelle (10), die Strom unter Nutzung des einfallenden Sonnenlichts erzeugt, und eine Verkapselung (20), die die Solarzelle (10) von außen abdichtet, enthält, und
ein zweites Modul (5b, 6b, 7b), das eine plattenförmige Farbschicht (70), die eine Farbe bildet und ein Hindurchgehen von Licht erlaubt, enthält,
wobei das farbvariable Solarmodul (5, 6, 7) weiterhin einen Fixierungsteil (120) umfasst, in dem eine Kopplungsstruktur erlaubt, dass das erste Modul (4, 6a, 7a) und das zweite Modul (5b, 6b, 7b) miteinander gekoppelt und voneinander getrennt werden,
**dadurch gekennzeichnet, dass** der Fixierungsteil (120) weiterhin einen drehbaren Scharnierteil (121) umfasst.

2. Farbvariables Solarmodul nach Anspruch 1, das weiterhin umfasst:
ein Abdeckungsfenster, das in einer geschichteten Struktur mit der Farbschicht vorgesehen ist.

3. Farbvariables Solarmodul nach Anspruch 2, wobei eine zweite Vertiefung oder Stufe konkav an einer Fläche des Abdeckungsfensters ausgebildet ist, und
der Fixierungsteil ein an dem ersten Modul angebrachtes Ende aufweist und das andere Ende einen in die zweite Nut oder Stufe gepassten Sperrvorsprung umfasst.

4. Farbvariables Solarmodul nach Anspruch 1, das weiterhin aufweist:
ein Abdichtungsglied, das zwischen dem ersten Modul und dem zweiten Modul angeordnet ist und die zwischen dem ersten Modul und dem zweiten Modul befindliche Luft abdichtet.

5. Farbvariables Solarmodul nach Anspruch 1, wobei der Fixierungsteil mit einer bestimmten Dicke oder Dichte ausgebildet ist, und
die Dicke des Scharnierteils dünner ist als die Dicke des Fixierungsteils oder die Dichte des Scharnierteils niedriger ist als die Dichte des Fixierungsteils.

6. Farbvariables Solarmodul nach Anspruch 4, wobei das Dichtungsglied aus einem Polymer, das durch Druck verformt werden kann, ausgebildet ist.

7. Farbvariables Solarmodul nach Anspruch 1, wobei der Fixierungsteil an dem zweiten Modul angebracht oder mit diesem gekoppelt ist,
wobei der Fixierungsteil weiterhin umfasst:
eine Passvertiefung, die konkav an einer sich von dem Scharnierteil erstreckenden Fläche ausgebildet ist, und
einen Passvorsprung, der an dem ersten Modul ausgebildet ist und der Passvertiefung entspricht.

## Revendications

1. Module solaire à couleur variable (5, 6, 7), comprenant :
un premier module (4, 6a, 7a) incluant une cellule solaire (10) générant de l'énergie en utilisant la lumière solaire incidente, et un encapsulant (20) scellant la cellule solaire (10) depuis l'extérieur ; et
un second module (5b, 6b, 7b) comprenant une couche de couleur en forme de plaque (70) formant une couleur et permettant la transmission de la lumière ;
dans lequel le module solaire à couleur variable (5,6,7) comprend en outre une partie de fixation (120) dans laquelle une structure de couplage permet au premier module (4,6a,7a) et au second module (5b, 6b, 7b) d'être couplés et séparés,
**caractérisé en ce que** la partie de fixation (120) comprend en outre une partie de charnière rotative (121).

2. Module solaire à couleur variable selon la revendication 1, comprenant en outre :
une fenêtre de couverture pourvue dans une structure en couches avec la couche de couleur.

3. Module solaire à couleur variable la revendication 2, dans lequel une seconde rainure ou une marche, formée pour être concave sur une surface de la fenêtre de couverture est formée, et
la partie de fixation présente une extrémité attachée au premier module et l'autre extrémité incluant une saillie de verrouillage ajustée dans la seconde rainure ou marche.

4. Module solaire à couleur variable selon la revendication 1, comprenant en outre :
un élément scellant situé entre le premier module et le second module, et scellant l'air situé entre le premier module et le second module.

5. Module solaire à couleur variable selon la revendication 1, dans lequel la partie de fixation est formée avec une certaine épaisseur ou densité, et
une épaisseur de la partie de charnière est plus fine que l'épaisseur de la partie de fixation ou une densité de la partie de charnière est inférieure à la densité de la partie de fixation.

6. Module solaire à couleur variable la revendication 4, dans lequel l'élément scellant est formé en un polymère qui est déformable en fonction de la pression.

7. Module solaire à couleur variable la revendication 1, dans lequel la partie de fixation est attachée à ou couplée au second module,
la partie de fixation comprenant en outre :
une rainure d'ajustement formée pour être concave sur une surface formée pour s'étendre depuis la partie de charnière, et
une saillie d'ajustement formée sur le premier module et correspondant à la rainure d'ajustement.
